# EUROPEAN PATENT APPLICATION

(11) **EP 4 615 174 A1**
(43) Date of publication of application: **10.09.2025**
(21) Application number: 23885571.2
(22) Date of filing: 23.10.2023
(51) Int. Cl.: H05K 3/28, H01L 23/12, H05K 3/06, H05K 3/44

(54) **METHOD FOR PRODUCING CIRCUIT BOARD**

(30) Priority: 31.10.2022 JP 2022175150
(71) Applicant: NHK Spring Co., Ltd., Kanagawa 236-0004 (JP)
(72) Inventor: YUKIMASA, Taro, Yokohama-shi, Kanagawa 236-0004 (JP); NUKUI, Kotaro, Yokohama-shi, Kanagawa 236-0004 (JP); KAMIKAWA, Kota, Yokohama-shi, Kanagawa 236-0004 (JP)
(74) Representative: DREISS Patentanwälte PartG mbB
(86) International application number: PCT/JP2023/038221
(87) International publication number: WO 2024/095811

(57) **Abstract**

In a structure in which a resin is filled in a gap between wiring patterns, a resin polishing step for removing resin that is on obverses of the wiring patterns is eliminated. A circuit board manufacturing method includes: a preparatory step of preparing a layered body in which a conductor layer, which structures wiring patterns, and a base substrate are layered via an insulating layer; a resin filling step of filling a thermosetting resin into a gap between the wiring patterns; and a complete curing step of heating the thermosetting resin and causing the thermosetting resin to flow in the gap between the wiring patterns, and thereafter, completely curing the thermosetting resin.

## Description

### Technical Field

The present disclosure relates to a circuit board manufacturing method.

### Background Art

Japanese Patent Application Laid-Open (JP-A) No. 2021-34534 discloses a circuit board in which a circuit portion and a base substrate are layered via an insulating layer. Wiring patterns are formed by etching on the metal plate that structures the circuit portion, and a resin that is different than that of the insulating layer is filled into the gap between the wiring patterns. Electronic components such as semiconductor elements for example are mounted to such a circuit board, and the electronic components and circuit board are sealed by a sealing resin.

### SUMMARY OF INVENTION

### Technical Problem

In recent years, accompanying the diversification of environments in which electronic equipment are used, an increase in the current capacity of circuit boards has been demanded. The current capacity of a circuit board can be increased by making the metal plate that structures the wiring patterns more thick. However, if the metal plate that structures the wiring patterns is made to be thicker, the sealing resin cannot sufficiently be filled between the wiring patterns in the resin sealing step, and there are cases in which peeling or air bubbles remain at the sealing resin and the insulating layer that includes the side surfaces of the wiring patterns. When voltage is applied to the circuit board in such a state, partial discharge occurs at the insulating layer from the wiring pattern end portions that are not covered by the sealing resin. Such partial discharge is a cause of dielectric breakdown.

With regard to this point, in the above-described prior art, resin is filled into the gap between the wiring patterns, and therefore, peeling of the sealing resin and the formation of air bubbles such as described above can be prevented. However, because the resin that is filled into the gap between the wiring patterns adheres to the obverses of the wiring patterns, a resin polishing step that removes the resin at the obverses of the wiring patterns is needed. In the resin polishing step, problems such as the buffing tool that is used in polishing becoming clogged occur.

In view of the above-described circumstances, an object of the present disclosure is to provide a circuit board manufacturing method that, in a structure in which a resin is filled in the gap between wiring patterns, can eliminate a resin polishing step for removing resin that is on the obverses of the wiring patterns. Solution to Problem

A circuit board manufacturing method of a first aspect has: a preparatory step of preparing a layered body in which a conductor layer, which structures wiring patterns, and a base substrate are layered via an insulating layer; a resin filling step of filling a thermosetting resin into a gap between the wiring patterns; and a complete curing step of heating the thermosetting resin and causing the thermosetting resin to flow in the gap, and thereafter, completely curing the thermosetting resin.

In accordance with the circuit board manufacturing method of the first aspect, in the preparatory step, a layered body in which a conductor layer, which structures wiring patterns, and a base substrate are layered via an insulating layer is prepared. In the resin filling step, a thermosetting resin is filled into an area that can freely design the wiring intervals between substrate products for example, and the thermosetting resin is thereby filled into the gap between the wiring patterns. In the complete curing step, the thermosetting resin that is between the wiring patterns is heated, and the thermosetting resin is made to flow between the narrow wiring patterns within the substrate unit, and thereafter is completely cured. Due to this flowing, the thermosetting resin can be made to spread well throughout the gap between the wiring patterns. As a result, in the resin filling step, there is no need to increase the filled amount of the thermosetting resin to the extent that the thermosetting resin adheres to the obverses of the wiring patterns. Due thereto, it becomes possible to eliminate a resin polishing step that is for removing the thermosetting resin that is on the obverses of the wiring patterns.

A circuit board manufacturing method of a second aspect has, in the first aspect and after the complete curing step, a plating step of carrying out plating on obverses of the wiring patterns without polishing the obverses.

In accordance with the circuit board manufacturing method of the second aspect, in the plating step that is after the complete curing step, plating is carried out on the obverses of the wiring patterns without polishing the obverses. Due to this plating, oxidation of the obverses of the wiring patterns can be prevented.

In a circuit board manufacturing method of a third aspect, in the first aspect or the second aspect, in the complete curing step, the thermosetting resin is cured in a state in which an obverse of the thermosetting resin is recessed in a curved shape as seen from a length direction of the gap.

In accordance with the circuit board manufacturing method of the third aspect, in the complete curing step, the thermosetting resin is cured in a state in which the obverse thereof is recessed in a curved shape as seen from the length direction of the gap between the wiring patterns, and the resin portion is formed. Due thereto, the step between the obverses of the wiring patterns and the obverse of the resin portion can be made smaller. As a result, in the resin sealing step that is after the mounting of components onto the wiring patterns for example, it is easy to fill the sealing resin into the aforementioned step portion, and it is easy to prevent peeling of the sealing resin and the formation of air bubbles.

### Advantageous Effects of Invention

As described above, in the circuit board manufacturing method relating to the present disclosure, in a structure in which a resin is filled in the gap between wiring patterns, a resin polishing step for removing resin that is on the obverses of the wiring patterns can be eliminated.

### BRIEF DESCRIPTION OF DRAWINGS

Fig. 1 is a drawing illustrating the structure of a perspective view illustrating a circuit board manufactured by a circuit board manufacturing method relating to an embodiment.
Fig. 2 is a cross-sectional view illustrating a cross-section cut along line F2-F2 of Fig. 1.
Fig. 3 is a chart illustrating manufacturing steps of the circuit board manufacturing method relating to the embodiment.
Fig. 4 is a cross-sectional view corresponding to Fig. 2 and illustrating a portion of an electronic module that is structured to include a circuit board relating to the embodiment.
Fig. 5 is a chart illustrating manufacturing steps of a circuit board manufacturing method relating to a comparative example.

### DESCRIPTION OF EMBODIMENTS

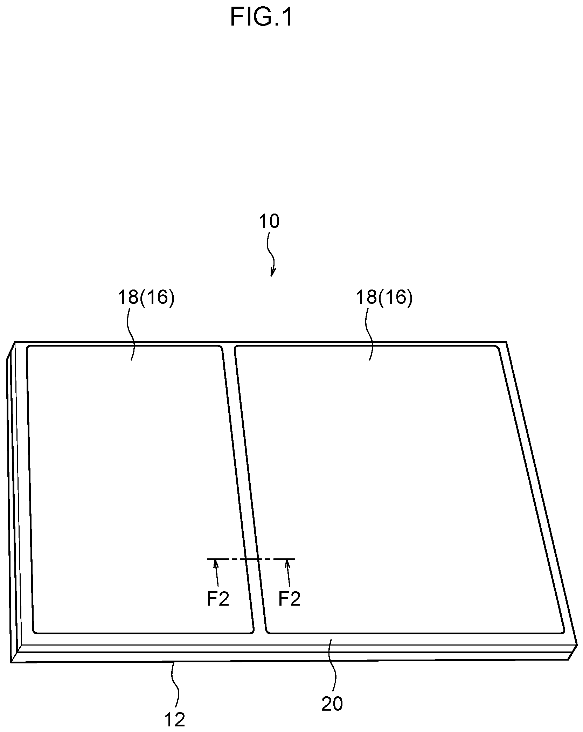

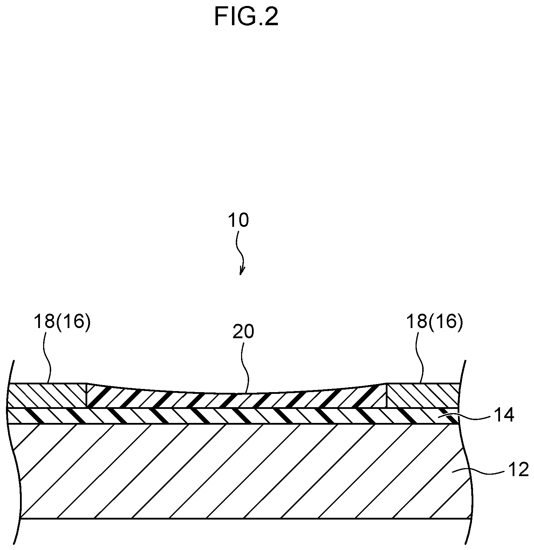

A circuit board manufacturing method relating to an embodiment of the present disclosure is described hereinafter with reference to Fig. 1 through Fig. 5. A circuit board 10 manufactured by the circuit board manufacturing method relating to the present embodiment is illustrated in a perspective view in Fig. 1. Electronic components (e.g., semiconductor elements) that are heat generating bodies are mounted on this circuit board 10. As illustrated in Fig. 1 and Fig. 2, the circuit board 10 has a metal base 12, an insulating layer 14 layered on the metal base 12, a metal layer 16 layered on the insulating layer 14 at the side opposite the metal base 12 and structuring wiring patterns (circuit patterns) 18, and a resin portion 20 filling in the gap between the wiring patterns 18. The metal base 12 corresponds to the "base substrate" in the present disclosure, and the metal layer 16 corresponds to the "conductor layer" in the present disclosure.

The metal base 12 is a substrate structured by a metal material. Materials having high thermal conductivity such as copper, copper alloys, aluminum and aluminum alloys for example are used as the material of the metal plate that structures the metal base 12. The thickness of the metal base 12 is set to be in the range of 1 mm to 3 mm for example. Note that there are cases in which an unillustrated heat dissipating means such as heat dissipating fins or a radiator is mounted to the surface of the metal base 12 which surface is at the side opposite the insulating layer 14.

The insulating layer 14 is a layer in which, for example, a filler that is insulating and thermally conductive is mixed into a synthetic resin that is electrically insulating. A synthetic resin that has good electrical insulating ability and thermal conductivity, such as an epoxy resin that is a thermosetting synthetic resin having an epoxy group, for example is used as the aforementioned synthetic resin. A filler that is chemically stable and has good thermal conductivity and electrical insulating ability such as silicon dioxide (silica) or aluminum oxide (alumina) for example is used as the aforementioned filler. The thickness of the insulating layer 14 is set to be in the range of 0.06 mm to 0.2 mm for example. Note that the insulating layer 14 may be a structure in which, instead of a filler that is thermally conductive, glass fibers are mixed into a synthetic resin that is electrically insulating.

The metal layer 16 is structured by a metal material that is electrically conductive for example. For example, a rolled copper plate or an aluminum plate is used as the metal material structuring the metal layer 16. The thickness of the metal layer 1 is set to be in the range of 0.3 mm to 1.5 mm for example. This metal layer 16 is a structure at which etching is carried out on a metal layer that is layered at the side of the insulating layer 14 opposite the metal base 12, and the metal layer 16 structures the predetermined wiring patterns 18. The obverses of the wiring patterns 18 are not polished, and metal plating (not illustrated) is carried out on these obverses. Note that the metal layer 16 may be a structure in which punching by a die press is carried out on a lead frame material for example. However, in the case of die pressing, it is easy for burrs and the like to form, and therefore, a step for removing the aforementioned burrs is needed before layering the metal layer 16 on the insulating layer 14.

The resin portion 20 is a structure in which an insulating and thermally conductive filler is mixed into a thermosetting resin such as an epoxy resin for example. Silicon dioxide (silica) or aluminum oxide (alumina) for example is used as this filler. The resin portion 20 is formed due to a thermosetting resin, which has been filled in the gap between the wiring patterns 18, being heated and made to flow in the gap, and thereafter, being completely cured (so-called C-stage cured). The gap between the wiring patterns 18 is filled in by this resin portion 20. As illustrated in Fig. 2, the obverse of the resin portion 20 is recessed in a curved shape toward the insulating layer 14 side as seen from the length direction of the gap between the wiring patterns 18. This recess is formed due to curing shrinkage of the thermosetting resin.

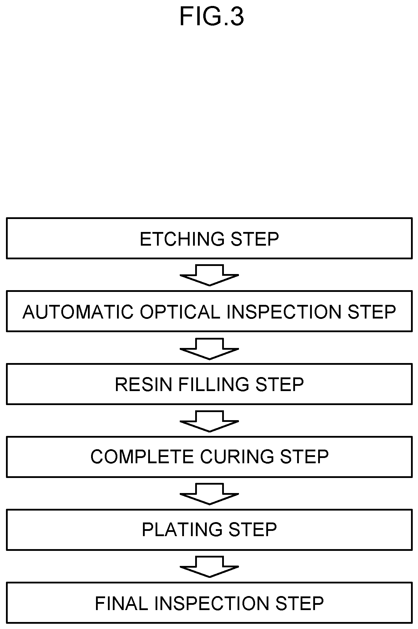

A circuit board manufacturing method for manufacturing the circuit board 10 of the above-described structure is described next. In Fig. 3, the manufacturing steps of the circuit board manufacturing method relating to the present embodiment are illustrated in a chart. In the circuit board manufacturing method relating to the present embodiment, first, a layered body, in which the metal base 12, the insulating layer 14 and the metal layer 16 are layered, is prepared, and the wiring patterns 18 are formed by carrying out etching on the metal layer 16.

A known method can be used as the method of manufacturing the above-described layered body. A liquid material (varnish material) can be coated as the material of the insulating layer 14 on at least one of the metal base 12 and the metal layer 16 by, for example, roll coating, bar coating or screen printing. Thereafter, the liquid material that is on the metal base 12 or on the metal layer 16 is dried by natural drying or forced drying. The insulating layer 14 is thereby obtained. The insulating layer 14 at this time may be in a state of not being cured completely (a so-called B-stage state). Next, the metal layer 16 is formed on the obverse of the insulating layer 14. Specifically, the metal layer 16 (e.g., a rolled copper plate) that is to become the wiring patterns 18 is layered by hot pressing or the like on the obverse of the insulating layer 14. The layered body, in which the metal layer 16 that structures the wiring patterns 18 and the metal base 12 are layered via the insulating layer 14, is thereby obtained.

In the etching step that is next, the metal layer 16 of the layered body that is obtained as described above is etched, and the predetermined wiring patterns 18 are formed. At the layered body after the etching step, inspection as to the absence/presence of defects is carried out in an automatic optical inspection step that is next. The above-described etching step and automatic optical inspection step correspond to the "preparatory step" in the present disclosure.

In the resin filling step that is next, a thermosetting resin, into which is mixed a filler that is insulating and thermally conductive, is filled into an area that can freely design the wiring interval between substrate products. Due thereto, the thermosetting resin is filled into the gap between the wiring patterns 18. This filling can be carried out by screen printing for example. At this time of this filling, the amount of the thermosetting resin that is filled in is adjusted such that adhesion of the thermosetting resin to the obverses of the wiring patterns 18 is prevented or suppressed.

In the complete curing step that is next, the thermosetting resin that has been filled into the gap between the wiring patterns 18 is heated and completely cured (C-stage cured). The heating temperature of the thermosetting resin in this complete curing step is set to be in the range of 150°C to 180°C for example. In this complete curing step, the thermosetting resin, whose flowability has been improved by heating, is made to flow within the gap between the wiring patterns 18, and thereafter, is completely cured. The resin portion 20 is thereby formed. The obverse of this resin portion 20 is recessed in a curved shape toward the insulating layer 14 side as seen from the length direction of the gap between the wiring patterns 18. Namely, in the complete curing step, the thermosetting resin can be made to flow by heating, and the thermosetting resin flows along the side surfaces of the wiring patterns 18, and due thereto, the end portions of the wiring patterns 18 can be covered by the thermosetting resin. As a result, the thermosetting resin after curing (i.e., the resin portion 20) is in a state in which the obverse thereof is recessed in a curved shape as seen from the length direction of the gap between the wiring patterns 18.

In the plating step that is next, without polishing the obverses of the wiring patterns 18 after the complete curing step, metal plating (not illustrated) is carried out on these obverses. The circuit board 10 is thereby completed. A plating liquid of copper or nickel for example is used in the metal plating. The thickness of the metal plating is set to be within the range of 0.1 µm to 0.4 µm for example. Oxidation of the obverses of the wiring patterns 18 can be prevented by this metal plating. The completed circuit board 10 is subjected to a final inspection in the final inspection step that is next.

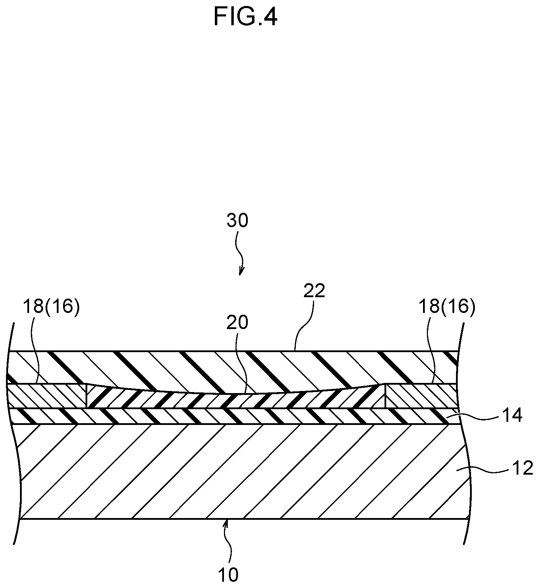

Unillustrated electronic components are mounted to the completed circuit board 10. Examples of these electronic components are semiconductor chips, transistors, diodes, light-emitting diodes, thyristors, capacitors, resistors, resistor arrays, coils and switches. These electronic components are joined to the obverses of the wiring patterns 18 by using an unillustrated, electrically-conductive joining material such as solder. The electronic components and the circuit board 10 are sealed by a sealing resin 22 (see Fig. 4). An electronic module 30 that has the circuit board 10, the electronic components and the sealing resin 22 is thereby completed. The aforementioned sealing resin 22 is molded by transfer molding for example.

Operation and effects of the present embodiment are described next.

In accordance with the present embodiment, in the preparatory step, a layered body, in which the metal layer 16 that structures the wiring patterns 18 and the metal base 12 are layered via the insulating layer 14, is prepared. In the resin filling step, a thermosetting resin is filled into the gap between the wiring patterns 18. In the complete curing step, the thermosetting resin that is between the wiring patterns 18 is heated and made to flow within the gap between the wiring patterns 18, and thereafter, is completely cured. Due to this flowing, the thermosetting resin can be made to spread well throughout the gap between the wiring patterns 18. As a result, in the resin filling step, there is no need to increase the filled amount of the thermosetting resin to the extent that the thermosetting resin adheres to the obverses of the wiring patterns 18. Due thereto, it becomes possible to eliminate a polishing step that removes the resin on the obverses of the wiring patterns 18.

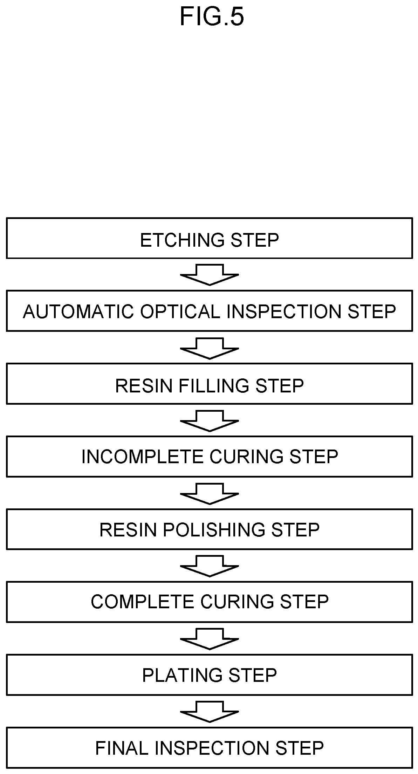

Supplemental description of the above-described effects is given with reference to Fig. 5. The manufacturing steps of a circuit board manufacturing method relating to a comparative example are illustrated in a chart in Fig. 5. In this comparative example, an incomplete curing step and a resin polishing step are provided between the resin filling step and the complete curing step, but other than that, the comparative example is similar to the present embodiment.

In this comparative example, in the resin filling step, in order to sufficiently fill the thermosetting resin into the gap between the wiring patterns, the thermosetting resin adheres to the obverses of the wiring patterns as well. In the incomplete curing step that is next, the thermosetting resin that exists at the obverses of the wiring patterns and in the gap between the wiring patterns is heated and cured incompletely (B-stage curing). In the resin polishing step that is next, the obverses of the wiring patterns are polished by using a ceramic buffing tool for example, and the resin that is on the obverses of the wiring patterns is removed. However, the mass producibility is poor because the ceramic buffing tool becomes clogged. In contrast, in the present embodiment, the mass producibility greatly improves because there is no need for the above-described incomplete curing step and resin polishing step.

Further, in accordance with the present embodiment, in the complete curing step, the thermosetting resin is cured in a state in which the obverse thereof is recessed in a curved shape as seen from the length direction of the gap between the wiring patterns 18, and the resin portion 20 is formed. Due thereto, the step between the obverses of the wiring patterns 18 and the obverse of the resin portion 20 can be made smaller. As a result, in the resin sealing step that is after the mounting of components onto the wiring patterns 18 for example, it is easy to fill the sealing resin 22 into the aforementioned step portion, and it is easy to prevent peeling of the sealing resin 22 and the formation of air bubbles.

Moreover, in accordance with the present embodiment, even in a case in which the thermosetting resin, which is filled into the gap between the wiring patterns 18, adheres to the obverses of the wiring patterns 18, it is easy for the filler that is contained in the thermosetting resin to precipitate in the gap. Due thereto, even in cases in which a resin polishing step is carried out, the number of times of polishing can be reduced.

Although the present disclosure has been described above by way of illustration of an embodiment, the present disclosure can be implemented by being modified in various ways within a scope that does not depart from the gist thereof. Further, the scope of the right of the present disclosure is, of course, not limited to the above-described embodiment.

The disclosure of Japanese Patent Application No. 2022-175150 filed on October 31, 2022 is, in its entirety, incorporated by reference into the present specification. All publications, patent applications, and technical standards mentioned in the present specification are incorporated by reference into the present specification to the same extent as if such individual publication, patent application, or technical standard was specifically and individually indicated to be incorporated by reference.

## Claims

1. A circuit board manufacturing method, comprising:
a preparatory step of preparing a layered body in which a conductor layer, which structures wiring patterns, and a base substrate are layered via an insulating layer;
a resin filling step of filling a thermosetting resin into a gap between the wiring patterns; and
a complete curing step of heating the thermosetting resin and causing the thermosetting resin to flow in the gap, and thereafter, completely curing the thermosetting resin.

2. The circuit board manufacturing method of Claim 1, comprising, after the complete curing step, a plating step of carrying out plating on obverses of the wiring patterns without polishing the obverses.

3. The circuit board manufacturing method of Claim 1 or Claim 2, wherein, in the complete curing step, the thermosetting resin is cured in a state in which an obverse of the thermosetting resin is recessed in a curved shape as seen from a length direction of the gap.
